(19) Europäisches Patentamt
European Patent Office
Office européen des brevets

(11) EP 2 494 672 B1

(12) FASCICULE DE BREVET EUROPEEN

(45) Date de publication et mention de la délivrance du brevet:
**09.11.2016 Bulletin 2016/45**

(21) Numéro de dépôt: **10768020.9**

(22) Date de dépôt: **20.10.2010**

(51) Int Cl.:
***B60L 11/18*** *(2006.01)*    ***H02J 3/14*** *(2006.01)*
***H02J 7/00*** *(2006.01)*    ***G01R 31/36*** *(2006.01)*

(86) Numéro de dépôt international:
**PCT/EP2010/065761**

(87) Numéro de publication internationale:
**WO 2011/051144 (05.05.2011 Gazette 2011/18)**

(54) **GESTION DE LA RECHARGE D'UN PARC DE BATTERIES**

VERWALTUNG DES WIEDERAUFLADENS EINES BATTERIESETS

MANAGEMENT OF THE RECHARGING OF A SET OF BATTERIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.10.2009 FR 0957622**

(43) Date de publication de la demande:
**05.09.2012 Bulletin 2012/36**

(73) Titulaire: **Commissariat à l'Énergie Atomique et aux Énergies Alternatives**
**75015 Paris (FR)**

(72) Inventeurs:
• **HA, Duy Long**
**38320 Eybens (FR)**
• **GENIES, Sylvie**
**38120 Saint Egreve (FR)**

(74) Mandataire: **Novaimo**
**Bâtiment Europa 2**
**310 avenue Marie Curie**
**Archamps Technopole**
**74166 Saint-Julien-en-Genevois Cedex (FR)**

(56) Documents cités:
**WO-A1-2009/069481**    **DE-C1- 19 519 107**
**US-A- 5 315 227**    **US-A- 5 548 200**
**US-A- 5 847 537**    **US-A1- 2008 238 357**

EP 2 494 672 B1

**Description**

L'invention concerne un procédé de gestion de la recharge d'au moins une batterie et un dispositif de recharge de batteries mettant en oeuvre un tel procédé.

Il existe de nombreux dispositifs fonctionnant à l'aide d'une batterie, comme par exemple les véhicules électriques ou hybrides. Lorsque l'utilisateur d'un tel dispositif électrique s'aperçoit que la charge de sa batterie est trop faible, il la relie à un dispositif de recharge qui exploite une source d'énergie électrique fournissant un courant de recharge de la batterie.

Lorsque le dispositif électrique concerné est un véhicule électrique, le dispositif de recharge de la batterie peut se présenter sous la forme d'un abri définissant une place de parking et équipé électriquement pour la connexion électrique avec la batterie. Un tel abri peut être équipé de panneaux photovoltaïques générant une énergie électrique qui est utilisée pour la recharge de la batterie du véhicule. Dans la pratique, le conducteur positionne son véhicule sous l'abri, le connecte électriquement à la source d'énergie de l'abri pour initier immédiatement la recharge de la batterie. La phase de recharge est ensuite automatiquement stoppée par le dispositif de recharge dès que la batterie atteint sa pleine charge.

Les dispositifs de recharge existants ne sont pas optimisés. En effet, la recharge des différentes batteries est initiée dès leur connexion électrique, avec pour objectif leur pleine charge. Or, cette recharge peut requérir une énergie provenant d'une source de production d'électricité coûteuse et/ou polluante au moment de la recharge de la batterie. De plus, cette source d'énergie peut être insuffisante à un instant donné, notamment si plusieurs batteries sont en charge simultanément et/ou si des sources d'énergie renouvelables sont utilisées, comme une source solaire ou éolienne, par nature fluctuante. D'autre part, la recharge totale de chaque batterie n'est peut-être pas nécessaire pour l'utilisation future envisagée.

On identifie également les documents US 2008/238357 A1 et US 5 548 200 A qui décrivent des procédés de gestion de la recharge d'au moins une batterie.

Ainsi, il existe un besoin d'un procédé de gestion intelligent de la recharge d'une ou plusieurs batterie(s) d'un dispositif électrique.

Un objet général de l'invention est donc de proposer une solution de gestion optimisée de la recharge d'au moins une batterie d'un dispositif électrique, qui atteint tout ou partie des objets particuliers suivants :

Un premier objet de l'invention est de proposer une solution de recharge d'une batterie à un coût optimisé, à un rendement énergétique optimal.

Un second objet de l'invention est de proposer une solution de recharge d'une batterie avec un impact minimal pour l'environnement.

Un troisième objet de l'invention est de proposer une solution de recharge d'une batterie compatible avec la recharge de plusieurs batteries, d'un maximum de batteries simultanément.

A cet effet, l'invention repose sur un procédé de gestion de la recharge d'au moins une batterie, caractérisé en ce qu'il comprend une transmission d'un niveau de charge souhaité ($C^i$) pour une batterie (i) à un instant donné ($T^i$) de sorte que la recharge permette à la batterie (i) d'atteindre un niveau de charge ($C(i)$) supérieur ou égal au niveau de charge souhaité ($C^i$) à l'instant donné.

L'invention est définie par les caractéristiques de la revendication indépendante. Les modes de réalisations préférés sont définis par les revendications dépendantes.

Le procédé de gestion de la recharge d'au moins une batterie peut mettre en oeuvre une recharge de chaque batterie (i) à une charge ($C(i)$) sensiblement égale à la charge souhaitée ($C^i$), respectant la condition suivante : $C^i \leq C(i) \leq 1,1\ C'$.

Le Procédé de gestion de la recharge peut comprendre une étape de mesure du niveau de charge initial ($C_o^i$) d'une batterie (i) puis une étape de mesure de son niveau de charge en cours de recharge.

Le procédé de gestion de la recharge d'au moins une batterie peut utiliser plusieurs sources (j) de production d'énergie électrique pour la recharge d'une batterie et comprendre une minimisation du coût total pour la recharge de la batterie, en minimisant la somme $\sum_{j=1}^{J} \int_0^{Ti} \text{Cost}\,(j,\,t)\,S(j,\,t)\,dt$ , où Cost($j, t$) représente le coût d'une unité d'énergie produite par une source j à un instant t et S($j, t$) la quantité d'énergie produite par une source j pour la recharge de la batterie à un instant t, J étant le nombre de sources d'énergie.

Le procédé de gestion de la recharge d'au moins une batterie peut comprendre une minimisation de l'impact environnemental de la recharge d'au moins une batterie, en minimisant la somme $\sum_{j=1}^{J} \int_0^{Ti} \text{Env}\,(j,\,t)\,S(j,\,t)\,dt,$

où Env(j, t) représente l'impact environnemental d'une unité d'énergie produite par une source j à un instant t.

Le procédé de gestion de la recharge d'au moins une batterie peut comprendre une minimisation de l'énergie totale $\sum_{j=1}^{J} \int_{0}^{Ti} S(j, t)\, dt$ utilisée pour la recharge d'au moins une batterie, et la prise en compte du maximum ($S_{max}^{j}$) d'énergie disponible pour chaque source de production par la condition $S(j, t) \leq S_{max}^{j}$.

Le procédé de gestion de la recharge d'au moins une batterie peut prendre en compte le rendement de recharge ($r_i(t)$) de chaque batterie à l'instant t, défini par $C(i) = C_0^i + \int_0^{Ti} ri(t)\, e(i, t)\, dt$, où $C_0^i$ représente le niveau de charge initial de la batterie et $e(i, t)$ représente l'énergie de recharge fournie à chaque batterie i à l'instant t.

L'invention porte aussi sur un dispositif de recharge d'au moins une batterie comprenant un moyen de liaison électrique avec au moins une batterie, caractérisé en ce qu'il comprend un calculateur qui met en oeuvre le procédé de gestion de la recharge d'au moins une batterie tel que décrit précédemment.

Le dispositif de recharge d'au moins une batterie peut comprendre un moyen de production d'énergie électrique solaire et/ou éolien.

Le dispositif de recharge d'au moins une batterie peut comprendre un moyen de communication pour la transmission d'un niveau de charge souhaité ($C^i$) pour une batterie (i) à un instant donné ($T^i$).

Ces objets, caractéristiques et avantages de la présente invention seront exposés en détail dans la description suivante d'un mode d'exécution particulier fait à titre non-limitatif en relation avec les figures jointes parmi lesquelles :

La figure 1 représente schématiquement le système mettant en oeuvre le procédé de recharge de batterie selon un mode d'exécution de l'invention.

La figure 2 représente l'évolution dans le temps de la charge de deux batteries et de l'énergie produite par un dispositif de recharge selon un exemple d'implémentation de l'invention.

Les figures 3a et 3b représentent l'évolution dans le temps des énergies transmises aux deux batteries.

L'invention va être illustrée dans le cas d'un parc de véhicules électriques à titre d'exemple. Un tel véhicule électrique peut être un vélo électrique, une voiture électrique, un segway, un scooter électrique, etc. Naturellement, l'invention pourrait être aisément transposée à tout dispositif électrique équipé d'une batterie pour son alimentation, nécessitant des phases de recharge de sa batterie. De plus, pour des raisons de simplification, il sera considéré dans la description suivante que chaque véhicule est équipé d'une seule batterie. Toutefois, le procédé pourrait naturellement être appliqué de manière similaire à des véhicules équipés de plusieurs batteries.

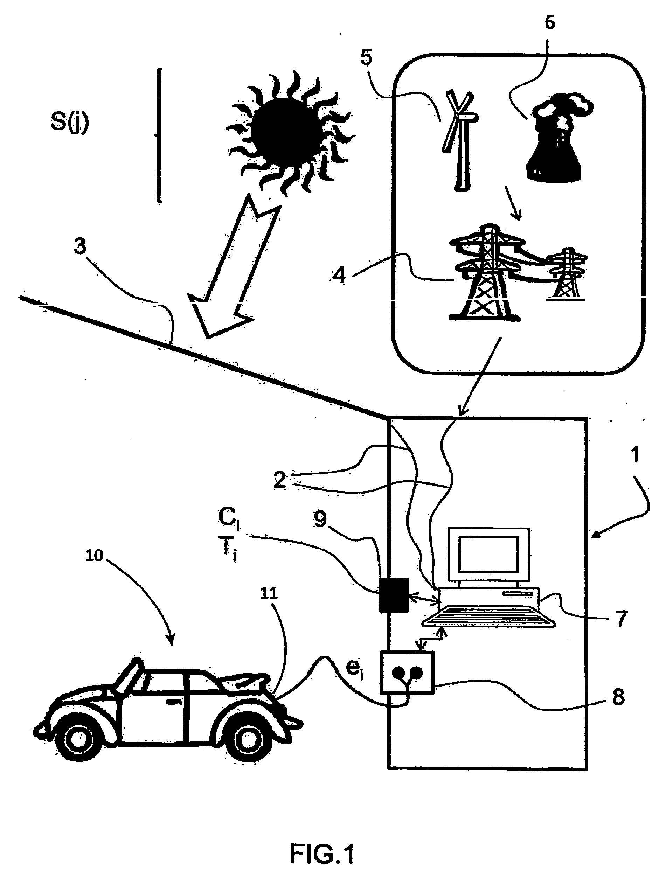

La figure 1 représente ainsi schématiquement un système mettant en oeuvre le procédé de la gestion de recharge de batterie selon un mode d'exécution de l'invention, dans lequel un dispositif de recharge de batteries 1, relié à une ou plusieurs sources de production d'énergie électrique S(j) par une liaison électrique 2, comprend un moyen de recharge de la batterie 11 d'un véhicule électrique 10.

L'invention repose sur le concept de prendre en compte le besoin de recharge de la batterie 11 d'un véhicule électrique 10. Ce besoin dépend généralement de la future utilisation envisagée et connue du véhicule électrique au moment de la mise en charge de sa batterie.

Ainsi, une étape essentielle du procédé de recharge de la batterie du véhicule électrique 10 comprend la transmission du besoin de recharge par l'utilisateur du véhicule, voire par le véhicule lui-même de manière automatisée en fonction de données d'itinéraires préalablement saisis par le conducteur, au dispositif de recharge 1. Ce besoin s'exprime par les deux paramètres suivants :

C représente le niveau de charge souhaité de la batterie,
T représente l'instant où le niveau de charge souhaité C doit être atteint, ou dépassé.

Ensuite, le procédé de recharge en tant que tel de la batterie tient naturellement compte de ce besoin, de sorte qu'à l'instant T, la charge de la batterie soit au moins égale à C, de préférence sensiblement égale ou légèrement supérieure à C, avantageusement supérieure au maximum à 10% cette charge C. En l'absence de l'information du besoin de charge, le procédé réalise la pleine charge de la batterie par défaut.

Le niveau de charge représente la quantité d'électricité ou d'énergie disponible dans la batterie. Ce niveau de charge sera déterminé à l'instant initial ($C_0$ à $t_0$) puis régulièrement, en temps réel ou quasi réel en cours de la recharge, par toute méthode connue de l'état de la technique, en général basée sur la mesure de paramètres électriques tels que la tension aux bornes de la batterie, la température et le courant au cours du temps. Le niveau de charge est donc le paramètre sur lequel se base le procédé de recharge de la batterie, notamment pour déterminer la fin de la recharge par la détection de la charge souhaitée C.

La mesure du niveau de charge de la batterie est effectuée par un dispositif intégré au véhicule électrique et associé à la batterie. En variante, cette mesure pourrait être effectuée par le dispositif de recharge 1.

De plus, le modèle de la batterie particulière d'un véhicule électrique donné est transmis au dispositif de recharge, afin notamment d'en déduire le rendement r du procédé de recharge, qui se définit comme le rapport entre l'énergie sortante de la batterie sur l'énergie de recharge qu'il a fallu injecter. Ce rendement dépend généralement du type de la batterie, et plus exactement de la technologie utilisée.

Le dispositif de recharge de la batterie fournit donc une certaine quantité d'énergie de recharge e à la batterie 11, à partir d'une certaine quantité d'énergie u supérieure produite par une ou plusieurs sources d'énergie S(j) disponibles et alimentant le dispositif de recharge. Finalement, la recharge de la batterie peut s'exprimer par les équations suivantes :

$$C = C_0 + u$$

$$u = r \, e$$

où C est le niveau de charge final obtenue et $C_0$ le niveau de charge initial.

Le procédé de recharge de la batterie selon le mode d'exécution de l'invention tient compte du fait que l'énergie électrique disponible à tout instant au niveau du dispositif de recharge n'est pas infinie, dépend des différentes sources reliées au dispositif de recharge. Cette énergie S(j) disponible pour chaque source d'énergie j est donc majorée par un maximum $S_{max}^j$.

Le procédé de recharge de la batterie repose sur l'exploitation de J sources de production d'énergie électrique j qui produisent une énergie électrique S(j) exploitée par le dispositif de recharge de batterie qui transmet une énergie électrique e(i) à chaque batterie i. Cette production d'énergie S(j) induit un coût Cost(j) et un impact environnemental Env(j) par unité d'énergie produite, qui peut se mesurer, incluant par exemple le rejet en $CO_2$ dans l'atmosphère. Tous ces paramètres sont variables au cours du temps.

Finalement, le procédé mis en oeuvre par l'invention peut prendre en compte la présence de plusieurs batteries i (au total I batteries) à recharger, vers une charge $C^i$ souhaitée à un instant $T^i$, à partir d'une charge initiale $C_0^i$.

Le procédé de recharge de la batterie résout donc tout ou partie des équations et conditions suivantes pour en déduire les conditions de charge de chaque batterie, à partir de quelle source de production électrique et à quel moment :

$$\text{A l'instant } T^i, \text{ la charge } C^i \text{ respecte } C(i) \geq C^i \qquad (1)$$

$$\sum_{i=1}^{I} e(i) = \sum_{j=1}^{J} S(j) \qquad (2)$$

$$\text{Minimiser } \sum_{j=1}^{J} \int_0^{Ti} \text{Cost}(j,t)\, S(j,t)\, dt \qquad (3)$$

$$\text{Minimiser } \sum_{j=1}^{J} \int_0^{Ti} \text{Env}(j,t)\, S(j,t)\, dt \qquad (4)$$

$$\text{Minimiser } \sum_{j=1}^{J} \int_0^{Ti} S(j,t)\, dt \qquad (5)$$

$$\text{Avec } S(j,t) \leq S_{max}^{\ j} \qquad (6)$$

$$\text{Avec } C(i) = r_i \, e(i) \qquad (7)$$

La condition (1) permet d'atteindre le niveau de charge souhaité par l'utilisateur pour chaque batterie et de respecter son besoin. De préférence, le niveau de charge final C(i) recherché est sensiblement égal au niveau de charge

souhaité $C^i$, le dépassant au maximum de 10%, et respectant donc la condition suivante : $C^i \leq C(i) \leq 1,1\ C^i$.

L'équation (2) représente l'équilibre énergétique du système entre l'énergie produite par les différentes sources de production d'énergie et l'énergie consommée pour la recharge.

Les conditions (3) et (4) permettent de réaliser la recharge respectivement au coût minimal et avec un impact minimal sur l'environnement.

La condition (5) permet d'effectuer la recharge à un rendement énergétique maximal.

Ces trois dernières conditions (3), (4), (5), favorisent la recharge durant les périodes où les sources d'énergie renouvelables (solaire, éolien..) présentent une production électrique élevée.

La condition (6) prend en compte le maximum de production électrique possible pour chaque source.

L'équation (7) fait intervenir le rendement $r_i$ de la recharge, qui dépend du type de la batterie i considérée. Ce rendement de la batterie est généralement obtenu expérimentalement. Il est en général non linéaire et le mode d'exécution de l'invention propose une discrétisation temporelle des équations et conditions précédentes et une transformation logique par variable binaire afin de pouvoir les écrire sous forme linéaire malgré la nature non linéaire du rendement r, et faciliter la résolution mathématique de ces équations, par exemple par une méthode de séparation et évaluation (« branch and bound » en terme anglo-saxon).

La résolution de ces conditions et équations permet d'obtenir l'énergie S(j) à produire et prélever sur chaque source d'énergie j pour charger chaque batterie i. Cette solution donne aussi la répartition dans le temps de ces énergies. Par la résolution de tout ou partie de ces conditions et équations, selon la complexité souhaitée de la mise en oeuvre de l'invention, il est possible d'assurer une gestion anticipative optimale de la gestion de la recharge des batteries. Cette solution représente un plan de recharge, pour un horizon glissant.

L'invention porte aussi sur un dispositif de recharge qui met en oeuvre le procédé de recharge de batteries tel que défini ci-dessus. Pour cela, le dispositif de recharge 1, représenté schématiquement sur la figure 1, comprend une liaison 2 avec une ou plusieurs sources de production d'énergie électrique S(j). Dans l'exemple illustré, il intègre des panneaux photovoltaïques 3 pour une production locale d'énergie électrique solaire. Il est de plus relié au réseau électrique 4 dont l'énergie électrique provient de différentes sources, comme des sources éoliennes 5 ou traditionnelles 6 (gaz, charbon, nucléaire...). Dans un tel cas, le procédé de gestion de la recharge de batterie peut comprendre une estimation de la production future d'énergie électrique solaire, notamment à partir de prévisions météorologiques.

Le dispositif de recharge 1 comprend une intelligence, sous la forme de tout type de calculateur 7, permettant la mise en oeuvre du procédé précédent, et notamment la résolution des équations mathématiques mentionnées, afin de déterminer les conditions de recharge de chaque batterie 11 connectée. Enfin, il comprend un moyen de liaison électrique 8 avec une batterie pour la mise en oeuvre de sa recharge et un moyen de communication 9 permettant la transmission de données avec le véhicule et/ou son conducteur comme le niveau de charge de la batterie, le besoin de charge souhaité. Ce dernier paramètre peut être transmis par le conducteur lui-même au dispositif de recharge par l'intermédiaire d'une interface homme-machine ou manuellement ou automatiquement par l'intermédiaire du véhicule électrique lui-même, à partir par exemple d'un calendrier électronique, d'un téléphone, d'un message électronique, etc.

L'invention permet ainsi d'atteindre les objets recherchés et présente finalement les avantages suivants :

- comme la recharge des batteries tient compte du besoin réel de chaque batterie, elle permet de gérer de manière optimale dans le temps la recharge des différentes batteries, aux moments les plus avantageux. De plus, elle permet de recharger en parallèle un maximum de batteries, puisqu'elle ne recherche pas obligatoirement la recharge maximale et immédiate de toutes les batteries connectées au dispositif de recharge ;
- la recharge dans le temps de la batterie permet aussi de tenir compte des différentes configurations des sources d'énergie électrique disponibles, et d'optimiser les charges durant des instants avantageux, en utilisant un maximum de sources d'énergie à faible coût et peu polluantes.

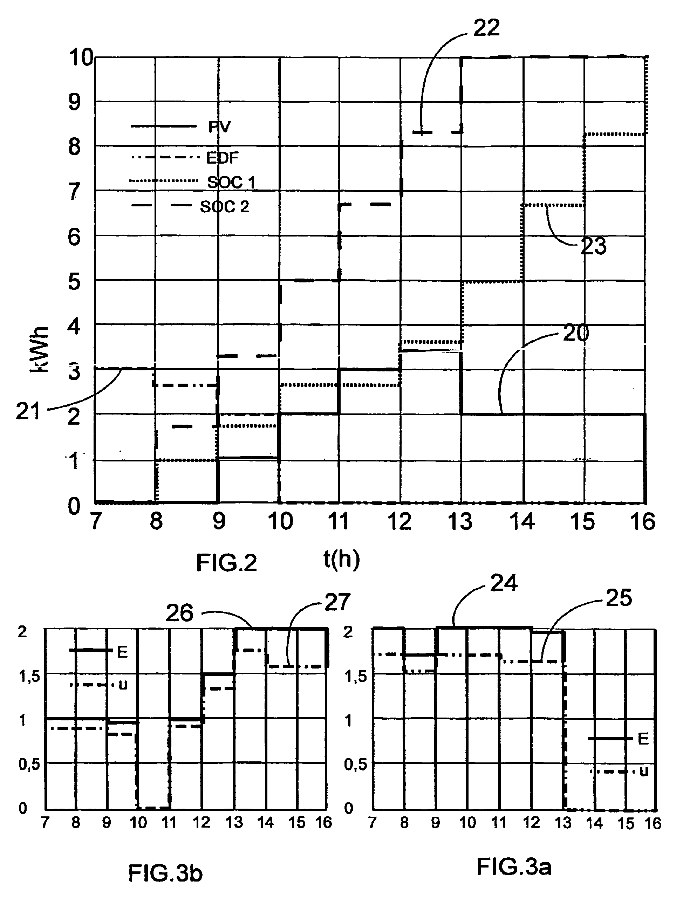

Les figures 2, 3a et 3b illustrent le résultat obtenu par un mode d'exécution particulier de l'invention, dans lequel deux dispositifs électriques doivent être rechargés à pleine charge, le premier pour 13H et le second pour 16H. Les deux dispositifs électriques sont connectés au dispositif de recharge vers 7H le matin. Le dispositif de recharge est connecté au réseau électrique national et comprend des panneaux photovoltaïques pour une capacité de 4 kW.

Les courbes 20 et 21 de la figure 2 représentent la variation dans le temps de respectivement la production électrique fournie par les panneaux photovoltaïques du dispositif de recharge et la production électrique issue du réseau électrique. Les courbes 22 et 23 illustrent respectivement les charges des deux batteries en fonction du temps. On remarque que pendant toute la période à ensoleillement important, l'énergie électrique exploitée provient essentiellement des panneaux photovoltaïques. L'énergie du réseau électrique n'est utilisée que tôt le matin. De plus, il apparaît bien que la gestion dans le temps de la recharge permet bien d'atteindre les besoins des deux dispositifs en terme de délai. La figure 3a comprend les courbes 24, 25 qui représentent respectivement l'énergie injectée dans la première batterie et l'énergie réellement accumulée dans cette batterie, en fonction du temps. Il ressort que cette énergie est forte et relativement constante de 7H à 13H. La différence entre les deux courbes provient du rendement de recharge de la batterie, et représente les pertes de la recharge, comme cela a été explicité auparavant. La figure 3b représente de manière similaire les courbes 26, 27 qui représentent respectivement l'énergie injectée dans la seconde batterie et l'énergie réellement accumulée dans cette batterie, en fonction du temps. Il ressort que cette énergie est faible et relativement constante de 7H à 13H et forte entre 13H et 16H. Cette répartition permet de privilégier dans un premier temps la recharge de la première batterie qui doit être prête plus tôt. On note que dans les premières heures où les deux batteries sont en charge et où l'ensoleillement est faible, le dispositif de recharge a recours à une certaine énergie électrique minimale provenant du réseau électrique.

**Revendications**

1. Procédé de gestion de la recharge d'au moins une batterie, **caractérisé en ce qu'**il comprend une transmission du besoin en niveau de charge souhaité $C^i$ pour une batterie i à un instant donné $T^i$ de l'utilisateur ou d'un véhicule vers un dispositif de recharge de sorte que la recharge permette à la batterie i d'atteindre un niveau de charge $C(i)$ supérieur ou égal au niveau de charge souhaité $C^i$ à l'instant donné et **en ce qu'**il utilise plusieurs sources j de production d'énergie électrique pour la recharge d'une batterie et **en ce qu'**il comprend une minimisation du coût total pour la recharge de la batterie, en minimisant la somme $\sum_{j=1}^{J} \int_{0}^{Ti} \mathrm{Cost}\,(j, t)\, S(j, t)\, dt$ , où Cost(j, t) représente le coût d'une unité d'énergie produite par une source j à un instant t et S(j, t) la quantité d'énergie produite par une source j pour la recharge de la batterie à un instant t, J étant le nombre de sources d'énergie.

2. Procédé de gestion de la recharge d'au moins une batterie selon la revendication précédente, **caractérisé en ce qu'**il met en oeuvre une recharge de chaque batterie i à une charge $C(i)$ sensiblement égale à la charge souhaitée $C^i$, respectant la condition suivante : $C^i \leq C(i) \leq 1,1\, C^i$.

3. Procédé de gestion de la recharge d'au moins une batterie selon l'une des revendications précédentes, **caractérisé en ce qu'**il comprend une étape de mesure du niveau de charge initial $C_0^i$ de chaque batterie i puis une étape de mesure de leur niveau de charge en cours de recharge.

4. Procédé de gestion de la recharge d'au moins une batterie selon l'une des revendications précédentes, **caractérisé en ce qu'**il comprend une minimisation de l'impact environnemental de la recharge d'au moins une batterie, en minimisant la somme $\sum_{j=1}^{J} \int_{0}^{Ti} \mathrm{Env}\,(j, t)\, S(j, t)\, dt,$ où Env(j, t) représente l'impact environnemental d'une unité d'énergie produite par une source j à un instant t.

5. Procédé de gestion de la recharge d'au moins une batterie selon l'une des revendications précédentes, **caractérisé en ce qu'**il comprend une minimisation de l'énergie totale $\sum_{j=1}^{J} \int_{0}^{Ti} S(j, t)\, dt$ utilisée pour la recharge d'au moins une batterie, et la prise en compte du maximum $S_{max}^j$ d'énergie disponible pour chaque source de production par la condition $S(j, t) \leq S_{max}^j$.

6. Procédé de gestion de la recharge d'au moins une batterie selon l'une des revendications précédentes, **caractérisé en ce qu'**il prend en compte le rendement de recharge $(r_i(t))$ de chaque batterie à l'instant t, par une étape de calcul selon l'équation $C(i) = C_0^i + \int_{0}^{Ti} ri(t)\, e(i, t)\, dt,$ où $C_0^i$ représente le niveau de charge initial de la batterie et e(i, t) représente l'énergie de recharge fournie à chaque batterie i à l'instant t.

7. Dispositif de recharge (1) d'au moins une batterie comprenant un moyen de liaison électrique (8) avec au moins une batterie, **caractérisé en ce qu'**il comprend un calculateur (7) qui met en oeuvre le procédé de gestion de la recharge d'au moins une batterie selon l'une des revendications précédentes.

8. Dispositif de recharge d'au moins une batterie selon la revendication précédente, **caractérisé en ce qu'**il comprend un moyen de production d'énergie électrique solaire (3) et/ou éolien.

9. Dispositif de recharge d'au moins une batterie selon la revendication 7 ou 8, **caractérisé en ce qu'**il comprend un moyen de communication (9) pour la transmission d'un niveau de charge souhaité $C^i$ pour une batterie i à un instant donné $T^i$.

**Patentansprüche**

1. Verfahren zur Verwaltung des Wiederaufladens mindestens einer Batterie, **dadurch gekennzeichnet, dass** es eine Weiterleitung des Bedarfs des gewünschten Ladezustands $C^i$ für eine Batterie i zu einem gegebenen Zeitpunkt $T^i$ von dem Benutzer oder einem Fahrzeug an eine Wiederaufladevorrichtung umfasst, derart dass die Wiederaufladung der Batterie i erlaubt, einen Ladezustand C(i) zu erreichen der höher als der oder gleich dem gewünschten Ladezustand $C^i$ zu dem gegebenen Zeitpunkt ist und dadurch, dass es mehrere Quellen j zur Erringung von elektrischen Energie für die Wiederaufladung einer Batterie verwendet, und dadurch, dass es eine Minimierung der Gesamtkosten für die Wiederaufladung der Batterie durch Minimieren der Summe $\sum_{j=1}^{j} \int_{0}^{Ti} Cost(j,t) \; S(j,t) \; dt$ umfasst, in der Cost (j,t) die Kosten einer durch eine Quelle j zu einem Zeitpunkt t erzeugten Energieeinheit und S(j, t) die Menge der durch eine Quelle j für die Wiederaufladung der Batterie zu einem Zeitpunkt t erzeugten Energie darstellt, wobei J die Anzahl der Energiequellen ist.

2. Verfahren zur Verwaltung des Wiederaufladens mindestens einer Batterie nach dem vorhergehenden Anspruch, **dadurch gekennzeichnet, dass** es ein Wiederaufladen jeder Batterie i auf eine Ladung C(i) einsetzt, die im Wesentlichen gleich der gewünschten Ladung Ci ist, unter Einhaltung der folgenden Bedingung: $C^i \le C(i) \le 1,1 \; C^i$.

3. Verfahren zur Verwaltung des Wiederaufladens mindestens einer Batterie nach einem der vorhergehenden Ansprüche, **dadurch gekennzeichnet, dass** es einen Schritt des Messens des Anfangsladezustands $C_o^i$ jeder Batterie i, dann einen Schritt des Messens ihres Ladezustands beim Wiederaufladen umfasst.

4. Verfahren zur Verwaltung des Wiederaufladens mindestens einer Batterie nach einem der vorhergehenden Ansprüche, **dadurch gekennzeichnet, dass** es eine Minimierung der Auswirkung auf die Umwelt durch das Wiederaufladen von mindestens einer Batterie durch Minimieren der Summe $\sum_{j=1}^{j} \int_{0}^{Ti} Env(j,t) \; S(j,t) \; dt$ umfasst, in der Env(j,t) die Auswirkung auf die Umwelt einer durch eine Quelle j zu einem Zeitpunkt t erzeugten Energieeinheit darstellt.

5. Verfahren zur Verwaltung des Wiederaufladens mindestens einer Batterie nach einem der vorhergehenden Ansprüche, **dadurch gekennzeichnet, dass** es eine Minimierung der zum Wiederaufladen mindestens einer Batterie verwendeten Gesamtenergie $\sum_{j=1}^{j} S(j,t) \; dt$ und der Berücksichtigung des Maximums $S_{max}^j$ der für jede Erzeugungsquelle durch die Bedingung $S(j,t) \le S_{max}^j$ verfügbaren Energie umfasst.

6. Verfahren zur Verwaltung des Wiederaufladens mindestens einer Batterie nach einem der vorhergehenden Ansprüche, **dadurch gekennzeichnet, dass** es den Wirkungsgrad des Wiederaufladens $(r_j(t))$ jeder Batterie zum Zeitpunkt t durch einen Berechnungsschritt gemäß der Gleichung $C(i) = Ch^i + \int_{0}^{Ti} ri(t) \; e(i, \; t)$ berücksichtigt, in der $Ch^i$ den Anfangsladezustand der Batterie darstellt und e(i, t) die jeder Batterie i zum Zeitpunkt t bereitgestellte Wiederaufladenergie darstellt.

7. Vorrichtung zum Wiederaufladen (1) mindestens einer Batterie, die ein Mittel zum elektrischen Verbinden (8) mit mindestens einer Batterie umfasst, **dadurch gekennzeichnet, dass** sie einen Rechner (7) umfasst, der das Verfahren zur Verwaltung des Wiederaufladens mindestens einer Batterie nach einem der vorhergehenden Ansprüche einsetzt.

8. Vorrichtung zum Wiederaufladen mindestens einer Batterie nach dem vorhergehenden Anspruch, **dadurch gekennzeichnet, dass** sie ein Mittel zur Erzeugung von elektrischer Sonnen- (3) und/oder Windenergie umfasst.

9. Vorrichtung zum Wiederaufladen mindestens einer Batterie nach Anspruch 7 oder 8, **dadurch gekennzeichnet, dass** sie ein Kommunikationsmittel (9) für die Weiterleitung eines gewünschten Ladezustands $C^i$ für eine Batterie i zu einem gegebenen Zeitpunkt $T^i$ umfasst.

**Claims**

1.  Method for managing the recharging of at least one battery, **characterized in that** it comprises the transmission of the need in a desired charge level $C^i$ for a battery i at a given instant $T^i$ of a user or of a vehicle to a recharging device such that the recharging enables the battery i to reach a charge level C(i) greater than or equal to the desired charge level $C^i$ at the given instant and **in that** it uses a number of electrical energy production sources j for the recharging of a battery and **in that** it comprises a minimization of the total cost for the recharging of the battery, by minimizing the sum $\sum_{j=1}^{J} \int_{0}^{Ti} \text{Cost}(j,t)\, S(j,t)\, dt$, in which Cost(j,t) represents the cost of a unit of energy produced by a source j at an instant t and S(j, t) represents the quantity of energy produced by a source j for the recharging of the battery at an instant t, J being the number of energy sources.

2.  Method for managing the recharging of at least one battery according to the preceding claim, **characterized in that** it implements a recharging of each battery i to a charge C(i) substantially equal to the desired charge $C^i$, observing the following condition: $C^i \leq C(i) \leq 1.1\, C^i$.

3.  Method for managing the recharging of at least one battery according to one of the preceding claims, **characterized in that** it comprises a step for measuring the initial charge level $C_0^i$ of each battery i then a step for measuring their charge level during recharging.

4.  Method for managing the recharging of at least one battery according to one of the preceding claims, **characterized in that** it comprises a minimization of the environmental impact of the recharging of at least one battery, by minimizing the sum $\sum_{j=1}^{J} \int_{0}^{Ti} \text{Env}(j,t)\, S(j,t)\, dt$, in which Env(j,t) represents the environmental impact of a unit of energy produced by a source j at an instant t.

5.  Method for managing the recharging of at least one battery according to one of previous Claims, **characterized in that** it comprises a minimization of the total energy $\sum_{j=1}^{J} \int_{0}^{Ti} S(j,t)\, dt$ used for the recharging of at least one battery, and the taking into account of the maximum $S_{max}^j$ energy available for each production source by the condition $S(j, t) \leq S_{max}^j$.

6.  Method for managing the recharging of at least one battery according to one of the preceding claims, **characterized in that** it takes into account the recharging efficiency ($r_i(t)$) of each battery at the instant t, by a calculation step according to the equation $C(i) = C_0^i + \int_{0}^{Ti} ri(t)\, e(i, t)\, dt$, in which $C_0^i$ represents the initial charge level of the battery and e(i, t) represents the recharging energy supplied to each battery i at the instant t.

7.  Device (1) for recharging at least one battery, comprising an electrical link means (8) with at least one battery, **characterized in that** it comprises a computer (7) which implements the method for managing the recharging of at least one battery according to one of the preceding claims.

8.  Device for recharging at least one battery according to the preceding claim, **characterized in that** it comprises a solar (3) and/or wind turbine electrical energy production means.

9.  Device for recharging at least one battery according to Claim 7 or 8, **characterized in that** it comprises a communication means (9) for the transmission of a desired charge level $C^i$ for a battery i at a given instant $T^i$.

$S(j)$

5

6

3

4

2

1

$C_i$
$T_i$

9

7

10

11

$e_i$

8

FIG.1

FIG.2    t(h)

FIG.3b

FIG.3a

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2008238357 A1
- US 5548200 A